(19) Europäisches Patentamt / European Patent Office / Office européen des brevets

(11) **EP 3 644 502 A1**

(12) **EUROPEAN PATENT APPLICATION**

(43) Date of publication:
**29.04.2020 Bulletin 2020/18**

(51) Int Cl.:
**H03F 1/56** (2006.01)    **H03F 3/181** (2006.01)
**G10H 1/00** (2006.01)    **G10H 3/18** (2006.01)
**G10H 3/14** (2006.01)

(21) Application number: **19204983.1**

(22) Date of filing: **24.10.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.10.2018  IT 201800009772**

(71) Applicant: **IK Multimedia Production SRL**
**41122 Modena (IT)**

(72) Inventors:
• **IORI, Enrico**
**DAVID (PA)**
• **BARBI, Davide**
**41030 BOMPORTO  MO (IT)**

(74) Representative: **Modiano, Micaela Nadia et al**
**Modiano & Partners**
**Via Meravigli, 16**
**20123 Milano (IT)**

(54) **PREAMPLIFICATION DEVICE FOR STRINGED ELECTRIC MUSICAL INSTRUMENTS**

(57)    A preamplification device (10) for stringed electric musical instruments, which comprises acquisition means (12) which are configured to receive in input and acquire an analog electrical signal originating from a stringed electric musical instrument (50), the acquisition means (12) and the stringed electric musical instrument (50) being electrically connected. The preamplification device (10) further comprises a potentiometer (14) which is configured to regulate a resistive input electrical impedance value $R_L$ encountered by the analog electrical signal, and a variable-gain amplifier (16) which is configured to automatically regulate a level of the analog electrical signal, applying a gain value G that depends on the resistive input electrical impedance value $R_L$.

*Fig. 1*

Fig. 6

Fig. 7

**Description**

The present invention relates to a preamplification device for stringed electric musical instruments which is particularly, although not exclusively, useful and practical in the field of amplification of electric guitars and/or electric bass guitars.

Stringed electric musical instruments are instruments in which the vibrations of the strings are detected and converted to an analog electrical signal by an electromagnetic device called a pickup. In essence, a pickup is constituted by a magnet that acts as a magnetic pole, around which a coil is wound. The strings of the instrument, which are made of ferromagnetic material, are immersed in the magnetic field generated by the pickup and, by vibrating, they induce a variation of that magnetic field and as a consequence a voltage at the terminals of the winding.

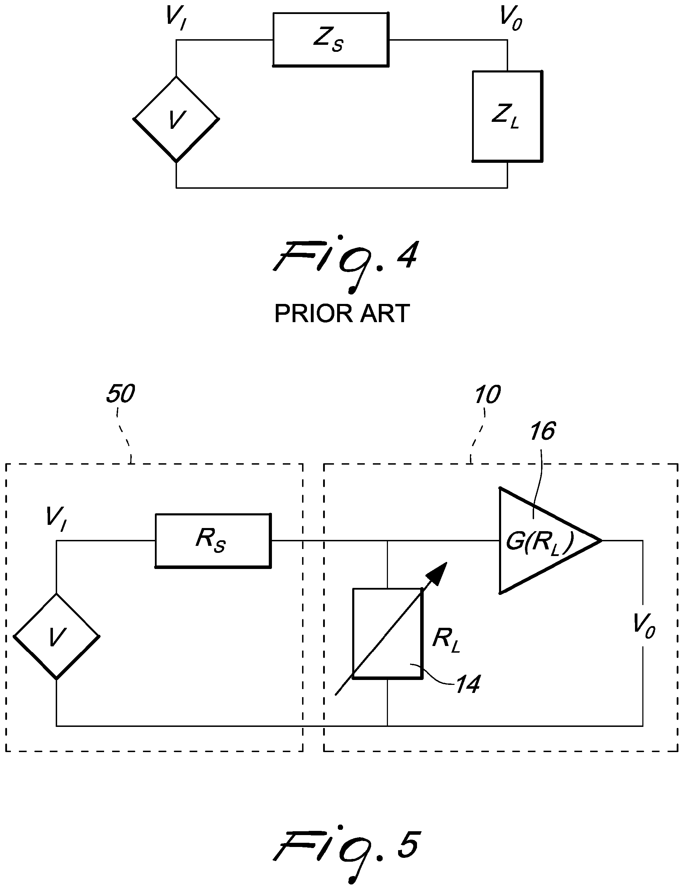

In general, it is known that any analog electrical signal, which is transmitted from a source electric musical instrument to a receiving apparatus, undergoes a conversion. In more detail, the original analog electrical signal $V_I$ is converted both from the output electrical impedance $Z_S$ of the source electric musical instrument and from the input electrical impedance (or load) $Z_L$ of the receiving apparatus, as shown in Figure 4 and according to the following formula:

$$\frac{V_O}{V_I} = \frac{Z_L}{Z_L + Z_S}$$

The output electrical impedance $Z_S$ is fixed, as it is a characteristic of the specific source electric musical instrument. Typically, the input electrical impedance $Z_L$ is also fixed for a specific receiving apparatus. Therefore, the same source electric musical instrument, depending on the receiving apparatus to which it is connected, generates a different acquired sound, which can be obtained only by way of a specific combination of source and receiver.

In most stringed electric musical instruments, the analog electrical signal of the pickup is sent out with no intermediate buffer and, in light of the above description, this fact implies that the characteristics of the signal, and as a consequence of the sound, are influenced by the input electrical impedance (or load) $Z_L$ of the receiving apparatus to which the instrument is connected, such as for example an amplifier, an effects pedal, a mixer, an audio interface, and the like.

For example, if the stringed electric musical instrument is connected to an effects pedal, which in turn is connected to an amplifier, the effects pedal determines the electrical impedance that is "seen" by the instrument and which influences the analog electrical signal of the pickup; but, if the effects pedal is removed, the amplifier determines the electrical impedance that is "seen" by the instrument and which influences the analog electrical signal of the pickup.

In fact, it is known that pickups for stringed electric musical instruments react differently depending on the apparatus to which they are connected, such as for example an amplifier or an effects pedal. The output electrical impedance $Z_S$ of the pickup, combined with the input electrical impedance (or load) $Z_L$ of the amplifier or of the effects pedal, forms a resonant circuit that models the frequency response of the instrument, and therefore the sound timbre of that instrument. The variations in input impedance (or load) $Z_L$ of the amplifier or of the effects pedal to which the instrument is connected can have a great influence on these resonance characteristics.

In brief, it follows from this that, on the one hand, different electrical load impedances generate different sound timbres for the same stringed electric musical instrument and, on the other hand, the same electrical load impedance generates different sound timbres starting from different stringed electric musical instruments.

In general, audio interface devices are known, for example constituted by electronic cards, which are used in order to connect the stringed electric musical instruments to processing units, such as for example computers or mobile devices.

Currently, audio interface devices are known which have a fixed input electrical impedance (or load), typically equal to 1 megaohm, a level that is substantially adapted to simulate the electrical impedance of a receiving apparatus to which the stringed electric musical instrument would be connected, such as for example an amplifier or an effects pedal.

1 megaohm is the recommended electrical impedance value for connecting stringed electric musical instruments, such as for example electric guitars or electric bass guitars, since, by providing an input with such a high electrical impedance value, it "loads" the pickup of the stringed electric musical instrument in a manner very similar to most amplifiers or effects pedals suitable for this type of instrument.

However, these conventional solutions are not devoid of drawbacks, among which is the fact that, under determined conditions of use, for example when using some particular effects or in some particular musical situations, the fixed input electrical impedance of 1 megaohm of the receiving audio interface device does not offer an optimal result, or indeed even a sufficient result, from the point of view of sound and music, as it produces analog electrical signals with sound timbres that are sometimes too harsh, i.e. with frequencies above 3 kHz.

Currently, audio interface devices are known which have a variable input electrical impedance (or load), which also is substantially adapted to simulate the electrical impedance of a receiving apparatus to which the stringed electric musical instrument would be connected, such as for example an amplifier or an effects pedal.

The possibility to vary the input impedance, automatically or manually, of the receiving audio interface device makes it possible to optimize the sound timbres of the resulting analog electrical signals.

However, even these conventional solutions are not devoid of drawbacks, among which is the fact that the variation of the input electrical impedance of the receiving audio interface device, for the same output electrical impedance of the source stringed electric musical instrument, produces a consequent and considerable variation in the level, i.e. of the volume, of the input analog electrical signal.

In practice, in these conventional types of solutions, an increase in the input impedance of the receiving audio interface device produces a consequent increase of the level of the input analog electrical signal and, conversely, a reduction in the input analog electrical signal of the receiving audio interface device produces a consequent reduction of the level of the input analog electrical signal.

Clearly, at the perceptive level, it is rather difficult, if not impossible, for a musician who is playing a stringed electric musical instrument to compare the different sounds obtained, in particular the different sound timbres, in order to creatively establish the optimal input impedance value (or load) of the receiving audio interface device if the level, i.e. the volume, of the input analog electrical signal is not constant over time.

The aim of the present invention is to overcome the limitations of the known art described above, by devising a preamplification device for stringed electric musical instruments that makes it possible to obtain better effects than those that can be obtained with conventional solutions and/or similar effects at lower cost and with higher performance levels.

Within this aim, an object of the present invention is to conceive a preamplification device for stringed electric musical instruments that enables a musician who is playing a stringed electric musical instrument, such as for example an electric guitar or an electric bass guitar, to obtain the sounds, in particular the sound timbres, that he or she knows and/or wants, i.e. the sounds as faithful as possible to the characteristics of the stringed electric musical instrument.

Another object of the present invention is to devise a preamplification device for stringed electric musical instruments that makes it possible to model the frequency response of a source stringed electric musical instrument, and therefore its sound timbre.

Another object of the present invention is to conceive a preamplification device for stringed electric musical instruments that makes it possible to vary the respective input electrical impedance (or load), in order to be able to obtain all the sounds, in particular the sound timbres, that a source stringed electric musical instrument could produce if it were connected to apparatuses with different input electrical impedances.

Another object of the present invention is to devise a preamplification device for stringed electric musical instruments that makes it possible to keep the level, i.e. the volume, of the input analog electrical signal substantially constant, compensating the variation of level owing to the variation of the input electrical impedance (or load).

Another object of the present invention is to provide a preamplification device for stringed electric musical instruments that is highly reliable, easily and practically implemented, and of low cost when compared to the known art.

This aim and these and other objects which will become better apparent hereinafter are achieved by a preamplification device for stringed electric musical instruments, which comprises acquisition means which are configured to receive in input and acquire an analog electrical signal originating from a stringed electric musical instrument, said acquisition means and said stringed electric musical instrument being electrically connected, characterized in that it comprises a potentiometer which is configured to regulate a resistive input electrical impedance value $R_L$ encountered by said analog electrical signal, and a variable-gain amplifier which is configured to automatically regulate a level of said analog electrical signal, applying a gain value G that depends on said resistive input electrical impedance value $R_L$.

Further characteristics and advantages of the invention will become better apparent from the description of some preferred, but not exclusive, embodiments of the preamplification device for stringed electric musical instruments according to the invention, which are illustrated by way of nonlimiting example with the aid of the accompanying drawings wherein:

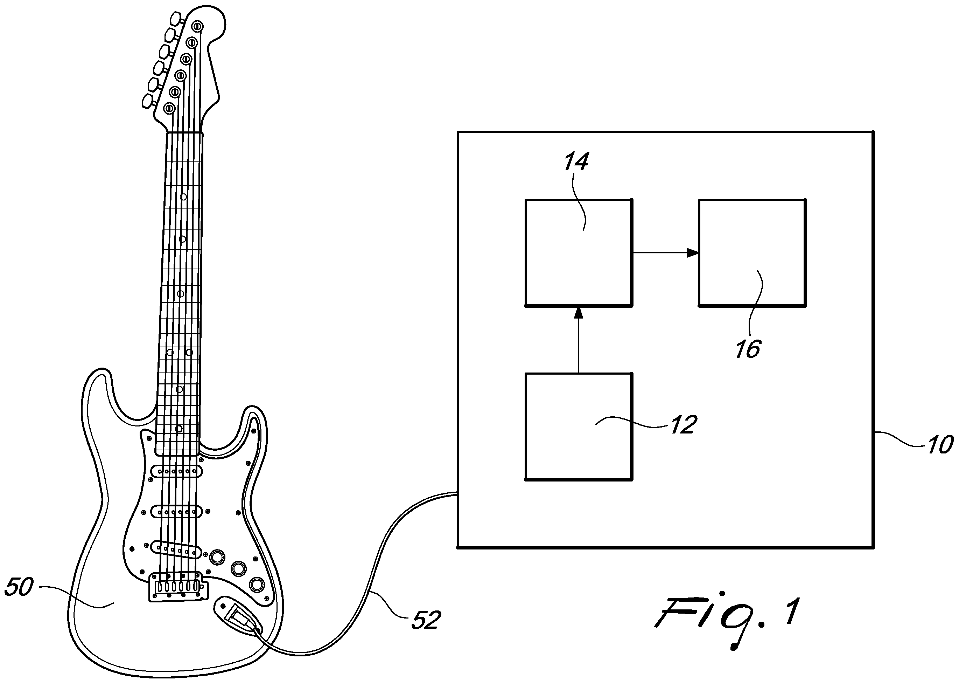

Figure 1 is a block diagram that schematically illustrates a first embodiment of the preamplification device for stringed electric musical instruments, according to the present invention, connected to an electric guitar;

Figure 2 is a block diagram that schematically illustrates a second embodiment of the preamplification device for stringed electric musical instruments, according to the present invention, connected to an electric guitar;

Figure 3 is a block diagram that schematically illustrates a third embodiment of the preamplification device for stringed electric musical instruments, according to the present invention, connected to an electric guitar;

Figure 4 is a block diagram that schematically illustrates the electronic circuit elements of a solution of conventional type;

Figure 5 is a block diagram that schematically illustrates the electronic circuit elements of a first embodiment of the preamplification device for stringed electric musical instruments, according to the present invention;

Figure 6 is a block diagram that schematically illustrates the electronic circuit elements of a second embodiment of the preamplification device for stringed electric musical instruments, according to the present invention;

Figure 7 is a block diagram that schematically illustrates the electronic circuit elements of a third embodiment of the preamplification device for stringed electric musical instruments, according to the present invention.

With reference to the figures, the preamplification device for stringed electric musical instruments according to the invention, generally designated by the reference numeral 10, substantially comprises acquisition means 12 of an electrical signal, a potentiometer 14, and a variable-gain amplifier 16.

The preamplification device 10 for stringed electric musical instruments is configured to amplify an analog electrical signal generated by a stringed electric musical instrument 50, such as for example an electric guitar or an electric bass guitar. The preamplification device 10 and the stringed electric musical instrument 50 are connected electrically, for example by way of an electric connection cable 52.

The acquisition means 12 of the preamplification device 10 according to the invention are configured to receive in input and acquire the analog electrical signal originating from the stringed electric musical instrument 50. The acquisition means 12 of the preamplification device 10 and the stringed electric musical instrument 50 are connected electrically, for example by way of the electric connection cable 52.

The potentiometer 14 of the preamplification device 10 according to the invention is configured to adjust the value of input electrical impedance (or load) $Z_L$, in particular of the respective resistive component $R_L$, encountered by the analog electrical signal in the preamplification device 10. The potentiometer 14 can be of the analog or digital type.

In practice, in the preamplification device 10 according to the invention, the analog electrical signal acquired by the acquisition means 12 encounters a value of input electrical impedance equal to the value set by the potentiometer 14.

Preferably, the potentiometer 14 comprises a control knob that can be operated by a user, in order to allow a musician to manually set, and therefore to his or her liking, the value of input electrical impedance $Z_L$, in particular of the respective resistive component $R_L$, of the preamplification device 10 according to the invention. In practice, by rotating the control knob of the potentiometer 14 in one direction and in the other direction, the musician can increase or decrease the resistive input electrical impedance value $R_L$ of the preamplification device 10 according to the invention.

In an embodiment, the potentiometer 14 is configured to adjust the value of input electrical impedance $Z_L$, in particular of the respective resistive component $R_L$, of the preamplification device 10 according to the invention within a range comprised between 1 megaohm and 10 kiloohm.

The variable-gain amplifier 16 of the preamplification device 10 according to the invention is configured to automatically adjust the level, i.e. the volume, of the resulting electrical signal from the preamplification device 10. The variable-gain amplifier 16 can be of the analog or digital type.

In particular, considering that the level of the resulting electrical signal is influenced mainly by the resistive component $R_L$ of the input electrical impedance (or load) $Z_L$ of the preamplification device 10 according to the invention, the variable-gain amplifier 16 is configured to compensate a variation of level, deriving from a variation of input electrical impedance $Z_L$ operated by the potentiometer 14, by applying a gain value G that depends on the setting of the value of input electrical impedance $Z_L$, in particular of the respective resistive component $R_L$, preferably as shown in Figures 5, 6 and 7 and according to the following formula:

$$\frac{V_O}{V_I} = G(R_L)\frac{R_L}{R_L + R_S}$$

The gain value G applied is such as to keep the level of the analog electrical signal substantially constant i.e., in practice, to keep the ratio between the output $V_O$ and input $V_I$ values equal to one ($V_O / V_I = 1$).

In this manner, the musician who is playing the stringed electric musical instrument 50 can compare the sounds, in particular the sound timbres, that correspond to different values of input electrical impedance set by the musician himself or herself, at a level, i.e. at a volume, that is uniform and constant, i.e. without variations of level that would negatively influence the perception of the sound, but retaining the characteristic reactive peculiarities of the specific configuration.

In more detail, a unity gain G is set as the input electrical impedance (or load) $R_L$ varies, according to the following formula:

$$G(R_L)\frac{R_L}{R_L + R_S} = 1$$

Starting from the above, the relationship is found for calculating the value of the gain G, according to the following formula:

$$G\left(R_{L}\right)=\frac{R_{L}+R_{S}}{R_{L}}$$

In an embodiment, the variable-gain amplifier 16 is configured to automatically regulate the level of the resulting electrical signal from the preamplification device 10 according to the invention, applying a gain value G that depends on the setting of the value of input electrical impedance $Z_{L}$, in particular of the respective resistive component $R_{L}$, the gain value G being calculated assuming a value of output electrical impedance $Z_{S}$, in particular of the respective resistive component $R_{S}$, of the stringed electric musical instrument 50 equal to 6.8 kiloohm, the gain G being calculated according to the following formula:

$$G\left(R_{L}\right)\approx\frac{R_{L}+6.8\,K}{R_{L}}$$

In fact, most stringed electric musical instruments used as a source have a resistive output impedance $R_{S}$ close to the approximate value of 6.8 kiloohm, which defines a compensation curve of the level of the resulting electrical signal that is actuated by the preamplification device 10 according to the invention.

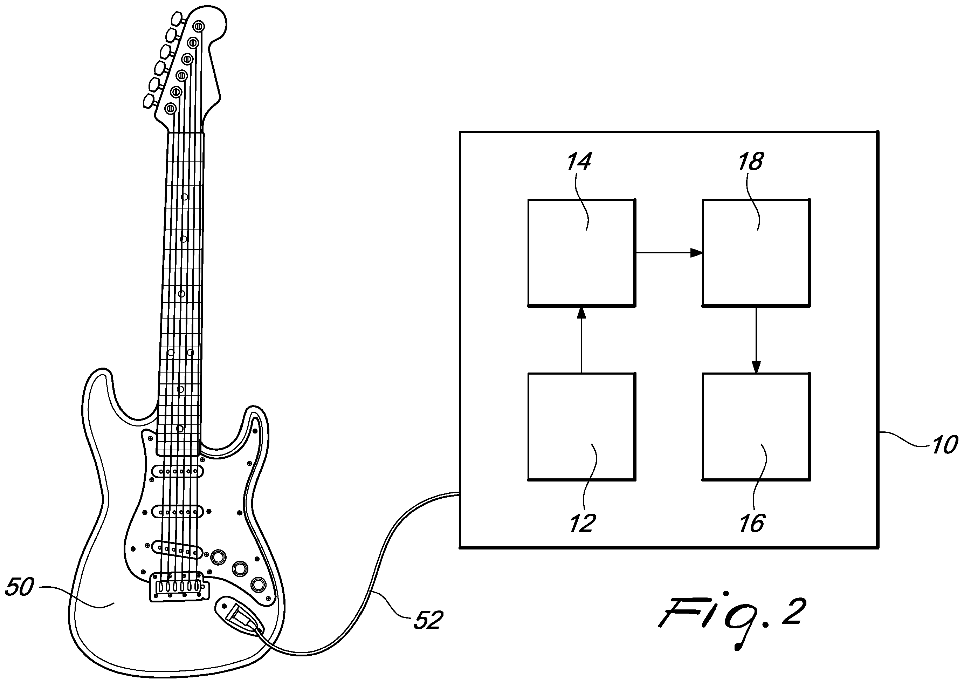

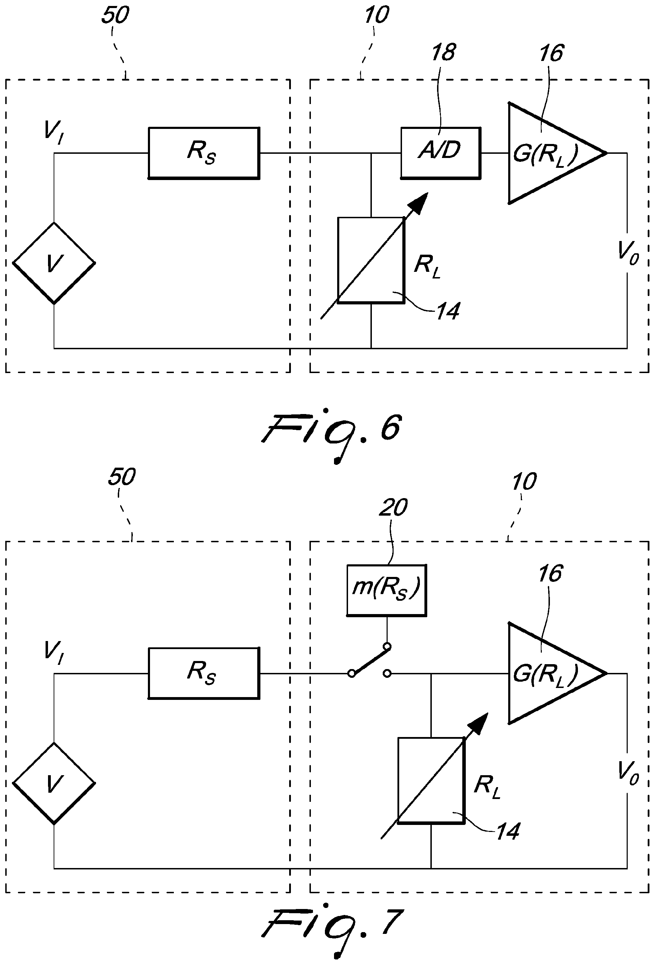

With particular reference to Figures 2 and 6, in a second embodiment of the invention, the preamplification device 10 for stringed electric musical instruments further comprises an analog/digital converter 18, arranged between the potentiometer 14 and the variable-gain amplifier 16.

The analog/digital converter 18 is configured to convert the analog electrical signal, acquired by the acquisition means 12, to a corresponding digital electrical signal. In this case, the variable-gain amplifier 16 is of the digital type.

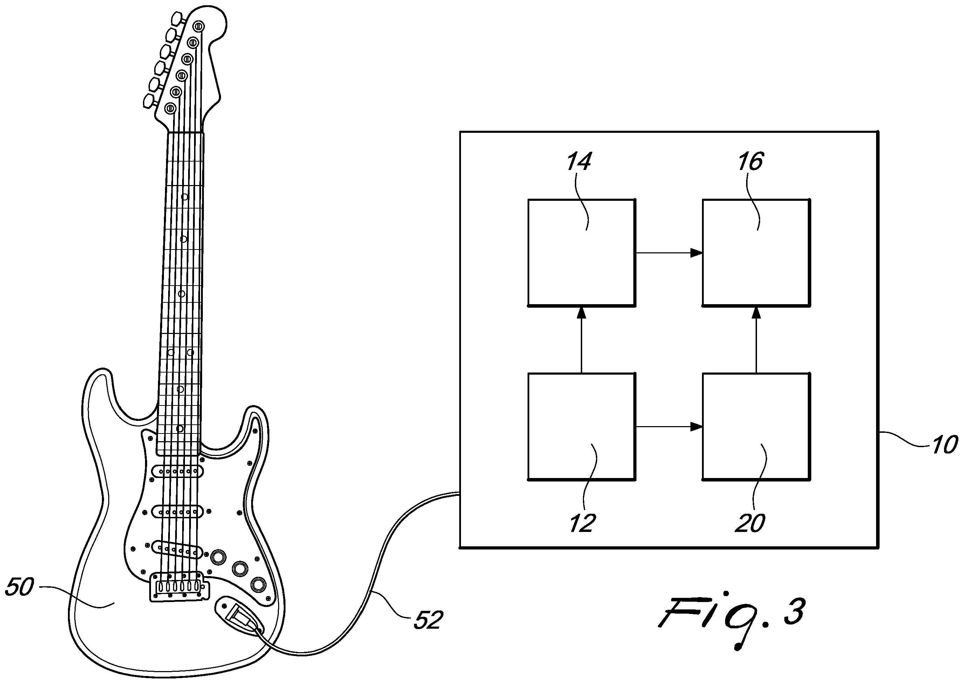

With particular reference to Figures 3 and 7, in a third embodiment of the invention, the preamplification device 10 for stringed electric musical instruments further comprises an impedance measurement device 20, arranged between the acquisition means 12 of the electrical signal and the variable-gain amplifier 16.

The impedance measurement device 20 is configured to measure the real value of output electrical impedance $Z_{S}$, in particular of the respective resistive component $R_{S}$, of the stringed electric musical instrument 50. The impedance measurement device 20 is further configured to set this real resistive output electrical impedance value $R_{S}$ in the variable-gain amplifier 16. In this manner, the variable-gain amplifier 16 can calculate an exact gain value G and then apply it to the level of the resulting electrical signal from the preamplification device 10 according to the invention, thus obtaining an exact compensation.

Advantageously, the preamplification device 10 for stringed electric musical instruments according to the invention comprises a box-like body (not shown), adapted to contain and protect the other elements of the preamplification device 10, such as for example the acquisition means 12, the potentiometer 14, the variable-gain amplifier 16, and the like, from impacts of various kinds which could cause damage to them.

In a preferred embodiment, the preamplification device 10 for stringed electric musical instruments according to the invention is in the form of an audio interface device associated with a processor, such as for example a computer or a mobile device, operable by a user, typically operated by the musician who is playing the stringed electric musical instrument 50, such as for example an electric guitar or an electric bass guitar.

In another embodiment, the preamplification device 10 for stringed electric musical instruments according to the invention is in the form of an electronic apparatus that is or can be installed on the stringed electric musical instrument 50, such as for example an electric guitar or an electric bass guitar.

In practice it has been found that the invention fully achieves the set aim and objects. In particular, it has been seen that the preamplification device for stringed electric musical instruments thus conceived makes it possible to overcome the qualitative limitations of the known art, in that it makes it possible to obtain better effects than those that can be obtained with conventional solutions and/or similar effects at lower cost and with higher performance levels.

An advantage of the preamplification device for stringed electric musical instruments according to the present invention consists in that it enables a musician who is playing a stringed electric musical instrument, such as for example an electric guitar or an electric bass guitar, to obtain the sounds, in particular the sound timbres, that he or she knows and/or wants, i.e. the sounds as faithful as possible to the characteristics of the stringed electric musical instrument.

Another advantage of the preamplification device for stringed electric musical instruments according to the present invention consists in that it makes it possible to model the frequency response of a source stringed electric musical instrument, and therefore its sound timbre.

Another advantage of the preamplification device for stringed electric musical instruments according to the present invention consists in that it makes it possible to manually vary the respective input electrical impedance (or load), in order to be able to obtain all the sounds, in particular the sound timbres, that a source stringed electric musical instrument could produce if it were connected to apparatuses with different input electrical impedances.

Another advantage of the preamplification device for stringed electric musical instruments according to the present invention consists in that it makes it possible to automatically keep the level, i.e. the volume, of the input analog electrical signal substantially constant, compensating the variation of level owing to the variation of the input electrical impedance (or load).

Although the preamplification device according to the invention has been conceived in particular for the preamplification of electric guitars and/or electric bass guitars, it can also be used, more generally, for any type of stringed electric musical instruments.

The invention, thus conceived, is susceptible of numerous modifications and variations, all of which are within the scope of the appended claims. Moreover, all the details may be substituted by other, technically equivalent elements.

In practice the materials employed, provided they are compatible with the specific use, and the contingent dimensions and shapes, may be any according to requirements and to the state of the art.

In conclusion, the scope of protection of the claims shall not be limited by the explanations or by the preferred embodiments illustrated in the description by way of examples, but rather the claims shall comprise all the patentable characteristics of novelty that reside in the present invention, including all the characteristics that would be considered as equivalent by the person skilled in the art.

The disclosures in Italian Patent Application No. 102018000009772 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

**Claims**

1. A preamplification device (10) for stringed electric musical instruments, which comprises acquisition means (12) which are configured to receive in input and acquire an analog electrical signal originating from a stringed electric musical instrument (50), said acquisition means (12) and said stringed electric musical instrument (50) being electrically connected, **characterized in that** it comprises a potentiometer (14) which is configured to regulate a resistive input electrical impedance value $R_L$ encountered by said analog electrical signal, and a variable-gain amplifier (16) which is configured to automatically regulate a level of said analog electrical signal, applying a gain value G that depends on said resistive input electrical impedance value $R_L$.

2. The preamplification device (10) for stringed electric musical instruments according to claim 1, **characterized in that** said gain value G is such as to keep said level of said analog electrical signal substantially constant.

3. The preamplification device (10) for stringed electric musical instruments according to claim 1 or 2, **characterized in that** said gain value G is calculated according to the formula:

$$G\left(R_L\right) = \frac{R_L + R_S}{R_L}$$

4. The preamplification device (10) for stringed electric musical instruments according to any one of the preceding claims, **characterized in that** said potentiometer (14) comprises a control knob which can be operated by a user in order to manually set said resistive input electrical impedance value $R_L$.

5. The preamplification device (10) for stringed electric musical instruments according to any one of the preceding claims, **characterized in that** said potentiometer (14) is configured to set said resistive input electrical impedance value $R_L$ within an interval comprised between 1 megaohm and 10 kiloohm.

6. The preamplification device (10) for stringed electric musical instruments according to any one of the preceding claims, **characterized in that** said gain value G applied to said level of said analog electrical signal by said variable-gain amplifier (16) is calculated assuming a resistive output electrical impedance value $R_S$ of said stringed electric musical instrument (50) equal to 6.8 kiloohm, said gain value G being calculated according to the formula:

$$G\left(R_L\right) \approx \frac{R_L + 6.8\,K}{R_L}$$

7. The preamplification device (10) for stringed electric musical instruments according to any one of claims 1 to 5, **characterized in that** it further comprises an impedance measurement device (20) which is configured to measure a real resistive output electrical impedance value $R_S$ of said stringed electric musical instrument (50), and is configured to set said real resistive output electrical impedance value $R_S$ in said variable-gain amplifier (16), in order to calculate said gain value G to be applied to said level of said analog electrical signal.

8. The preamplification device (10) for stringed electric musical instruments according to any one of the preceding claims, **characterized in that** said variable-gain amplifier (16) is of the analog type.

9. The preamplification device (10) for stringed electric musical instruments according to any one of claims 1 to 7, **characterized in that** said variable-gain amplifier (16) is of the digital type, said preamplification device (10) further comprising an analog/digital converter (18) which is configured to convert said analog electrical signal to a corresponding digital electrical signal.

10. The preamplification device (10) for stringed electric musical instruments according to any one of the preceding claims, **characterized in that** it comprises a box-like body that is adapted to contain and protect other elements of said preamplification device (10) from impacts of various kinds.

11. The preamplification device (10) for stringed electric musical instruments according to any one of the preceding claims, **characterized in that** said preamplification device (10) is in the form of an audio interface device associated with a processor that can be operated by said user.

12. The preamplification device (10) for stringed electric musical instruments according to any one of the preceding claims 1 to 10, **characterized in that** said preamplification device (10) is in the form of an electronic apparatus that is or can be installed on said stringed electric musical instrument (50).

Fig.1

EP 3 644 502 A1

Fig.2

10

16

20

14

12

*Fig. 3*

52

50

$$Fig.4$$

PRIOR ART

$$Fig.5$$

Fig.6

Fig.7

Europäisches
Patentamt

European
Patent Office

Office européen
des brevets

# EUROPEAN SEARCH REPORT

Application Number

EP 19 20 4983

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2007 110369 A (SHARP KK) 26 April 2007 (2007-04-26) * claims 1, 4 * * digital signal; paragraphs [0014], [0022], [0041] * | 1-12 | INV. H03F1/56 H03F3/181 G10H1/00 G10H3/18 |
| Y | EP 2 237 569 A1 (HARMAN INT IND [US]) 6 October 2010 (2010-10-06) * paragraph [0061] - paragraph [0082]; claims 1,2; figures 1,3, 8 * * impedance measurement; paragraphs [0050], [0083] - paragraph [0093]; figure 13 * * attempt to make G(f) more constant; paragraph [0083] - paragraph [0085]; figures 10-12 * | 1-6,8 | ADD. G10H3/14 |
| Y | CN 101 640 829 A (CHINESE ACAD INST ACOUSTICS) 3 February 2010 (2010-02-03) * page 5; claims 1-4; figure 3 * | 9 | |
| Y | US 2005/134374 A1 (HENCH JOHN J [US] ET AL) 23 June 2005 (2005-06-23) * paragraph [0116] - paragraph [0122]; figures 13A,13B * * paragraph [0022] - paragraph [0031]; figures 4, 6A, 6B * * paragraph [0057] - paragraph [0072]; figure 7A * * paragraph [0111] - paragraph [0115]; figures 10-12 * | 7,8 | TECHNICAL FIELDS SEARCHED (IPC) H03F G10H H04R |
| X | CN 2 078 479 U (ZHAO ZHICHENG [CN]) 5 June 1991 (1991-06-05) | 1 | |
| Y | * claims 1-4; figures 1, 4 * | 9-12 | |
| Y | EP 2 786 485 A1 (QUILTER LABS LLC [US]) 8 October 2014 (2014-10-08) | 1,7,9 | |
| A | * claims 1, 11; figure 2.3 * | 4 | |

The present search report has been drawn up for all claims

| Place of search | Date of completion of the search | Examiner |
|---|---|---|
| Munich | 13 February 2020 | Glasser, Jean-Marc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 20 4983

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2020

| Patent document cited in search report | | Publication date | Patent family member(s) | | Publication date |
|---|---|---|---|---|---|
| JP 2007110369 | A | 26-04-2007 | JP 4721859 B2<br>JP 2007110369 A | | 13-07-2011<br>26-04-2007 |
| EP 2237569 | A1 | 06-10-2010 | CN 101895804 A<br>EP 2237569 A1<br>JP 5010006 B2<br>JP 2010246115 A<br>US 2010246848 A1 | | 24-11-2010<br>06-10-2010<br>29-08-2012<br>28-10-2010<br>30-09-2010 |
| CN 101640829 | A | 03-02-2010 | NONE | | |
| US 2005134374 | A1 | 23-06-2005 | NONE | | |
| CN 2078479 | U | 05-06-1991 | NONE | | |
| EP 2786485 | A1 | 08-10-2014 | CA 2857142 A1<br>CN 104081663 A<br>EP 2786485 A1<br>US 2013136278 A1<br>WO 2013082166 A1 | | 06-06-2013<br>01-10-2014<br>08-10-2014<br>30-05-2013<br>06-06-2013 |

For more details about this annex : see Official Journal of the European Patent Office, No. 12/82

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IT 102018000009772